Europäisches Patentamt

European Patent Office

Office européen des brevets

(19)

(11) EP 0 803 067 B1

# (12) FASCICULE DE BREVET EUROPEEN

(45) Date de publication et mention
de la délivrance du brevet:
**20.10.1999  Bulletin 1999/42**

(21) Numéro de dépôt: **96901041.2**

(22) Date de dépôt: **10.01.1996**

(51) Int Cl.⁶: **G01R 15/18**

(86) Numéro de dépôt international:
**PCT/FR96/00040**

(87) Numéro de publication internationale:
**WO 96/21864 (18.07.1996 Gazette 1996/33)**

(54) **CONVERTISSEURS DE TENSION BIDIRECTIONNELS DE TYPE CONTINU-CONTINU ET CAPTEUR DE COURANT**

BIDIREKTIONALER GLEICHSPANNUNG-GLEICHSPANNUNG-UMFORMER UND STROMWANDLER

TWO-WAY DC-TO-DC VOLTAGE CONVERTERS AND CURRENT SENSOR

(84) Etats contractants désignés:
**DE DK GB IE NL SE**

(30) Priorité: **13.01.1995  FR 9500542**

(43) Date de publication de la demande:
**29.10.1997   Bulletin 1997/44**

(73) Titulaire: **SEXTANT AVIONIQUE (Société Anonyme)**
**78141 Velizy Villacoublay (FR)**

(72) Inventeur: **TAURAND, Christophe**
**F-26000 Valence (FR)**

(74) Mandataire: **de Beaumont, Michel et al**
**1bis, rue Champollion**
**38000 Grenoble (FR)**

(56) Documents cités:

| | |
|---|---|
| EP-A- 0 105 049 | EP-A- 0 460 573 |
| DE-A- 3 511 710 | DE-A- 4 033 400 |
| US-A- 5 068 776 | US-A- 5 196 784 |
| US-A- 5 233 287 | |

## Description

La présente invention concerne le domaine des alimentations à découpage, et plus particulièrement celui des convertisseurs de tension à stockage inductif de type continu-continu. De tels convertisseurs, qui permettent de transformer des tensions continues, trouvent de nombreuses applications dans l'industrie et notamment dans le domaine aéronautique, où on les utilise pour produire, à partir du réseau électrique continu des aéronefs, des tensions de 5V, ±12V, ±15V,... destinées à alimenter des équipements électroniques embarqués.

De façon générale, le fonctionnement des convertisseurs à stockage inductif est basé sur la réalisation de cycles de transfert d'énergie comprenant une période d'accumulation d'une énergie magnétique dans un élément inductif, par l'intermédiaire d'un circuit primaire, suivie d'une période de restitution de cette énergie dans une charge à alimenter, par l'intermédiaire d'un circuit secondaire. On appelle convertisseur "buck-boost" un convertisseur dont l'élément inductif est une inductance à un seul enroulement, et convertisseur "fly-back" un convertisseur dont l'élément inductif est un transformateur comprenant au moins deux enroulements.

Dans ce domaine, la présente invention concerne plus particulièrement les convertisseurs de tension bidirectionnels, pouvant transférer de l'énergie aussi bien dans le sens du primaire vers le secondaire que dans le sens du secondaire vers le primaire. Ce type de convertisseur bidirectionnel convient particulièrement bien à l'alimentation de charges complexes (capacitives et/ou inductives), d'accumulateurs, ou encore de dispositifs réversibles comme des moteurs électriques, susceptibles de renvoyer de l'énergie vers le convertisseur.

Des exemples de convertisseurs bidirectionnels à stockage inductif sont décrits dans le brevet américain 3,986,097, relatif à des convertisseurs de type "fly-back", ainsi que dans le brevet américain et 4,736,151 et la demande de brevet européen 336 725, relatifs à des convertisseurs de type "buck-boost".

Un objectif général de la présente invention est d'améliorer ces convertisseurs bidirectionnels, dont on décrira tout d'abord le fonctionnement.

La figure la représente le schéma de base d'un convertisseur "buck-boost" bidirectionnel classique. On distingue dans un tel convertisseur, de part et d'autre d'une inductance L, un circuit primaire et un circuit secondaire. Le circuit primaire comprend une diode Dp et un interrupteur hacheur Tp montés en parallèle, l'ensemble étant interposé entre une source de tension d'alimentation Vin et l'inductance L. De façon similaire, le circuit secondaire comprend un ensemble diode/interrupteur hacheur Ds/Ts interposé entre l'inductance L et une capacité de sortie Cout. La capacité Cout assure le lissage de la tension de sortie Vout du convertisseur, appliquée à une charge Z à alimenter. Dans la pratique, les interrupteurs Tp, Ts sont des interrupteurs électroniques comme des transistors MOS ou des transistors bipolaires.

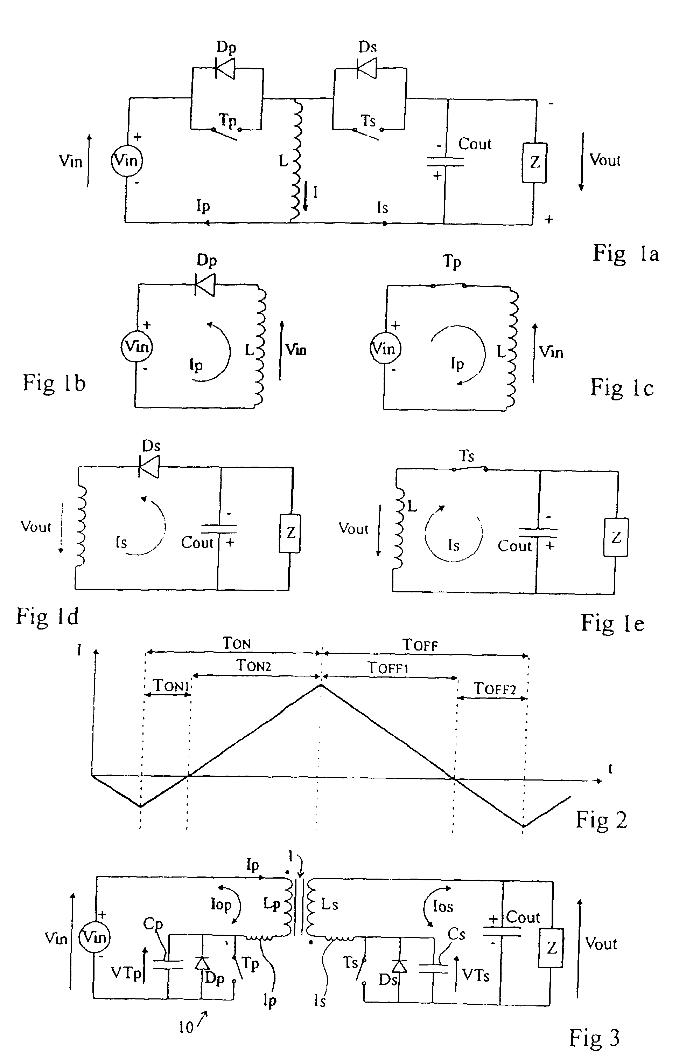

Comme évoqué plus haut, le fonctionnement du convertisseur se déroule en cycles de deux périodes, comprenant chacun une première période dite d'accumulation, de durée Ton, où un courant Ip circule dans le primaire, et une deuxième période dite de restitution, de durée Toff, où un courant Is circule dans le secondaire. La figure 2 représente le courant total I traversant l'inductance L pendant la durée d'un cycle. En mode de fonctionnement bidirectionnel, la période dite d'accumulation Ton comprend en fait une première phase Ton1 de restitution dans la source de tension Vin d'une énergie excédentaire accumulée dans l'inductance L au cours d'un cycle précédent, suivie d'une phase Ton2 d'accumulation effective d'une énergie magnétique dans l'inductance L. Les figures 1b et 1c représentent des schémas équivalents du convertisseur au cours des phases Ton1, Ton2. Pendant Ton1, l'inductance L génère le courant Ip qui est négatif (diode Dp passante, fig. 1b). Lorsque cette énergie a été entièrement restituée, commence la phase d'accumulation Ton2, où Ip est positif (Tp fermé, diode Dp bloquée, fig. 1c). De même, la phase dite de restitution Toff comprend tout d'abord une phase Toff1 de restitution effective dans la capacité Cout et la charge Z de l'énergie stockée par l'inductance L pendant Ton2, suivie d'une phase Toff2 d'accumulation dans l'inductance L d'une énergie excédentaire fournie à la capacité Cout ou à la charge Z pendant Toff1. Les figures ld et le représentent des schémas équivalents du convertisseur au cours des phases Toff1, Toff2. On voit que le courant secondaire Is est positif pendant Toff1 (diode Ds passante, fig. 1d), puis négatif pendant Toff2 (Ts fermé, diode Ds bloquée, fig. 1e), la charge Z ou la capacité Cout se comportant comme un générateur de tension. L'énergie stockée pendant Toff2 est transférée à la source de tension Vin lors de la phase Ton1 du cycle suivant, ce qui caractérise un fonctionnement bidirectionnel.

Un inconvénient de ce type de convertisseur est de présenter un rendement qui diminue quand la fréquence de fonctionnement s'élève, alors que, de façon contradictoire, il est préférable de choisir des fréquences de fonctionnement élevées, de l'ordre de 100 kHz à 1 MHz, pour réduire la taille et l'encombrement du convertisseur.

Il est bien connu que la diminution du rendement avec l'augmentation de la fréquence de fonctionnement est notamment causée par des pertes d'énergie dans les interrupteurs pendant les périodes de commutations. On rappelle que l'énergie perdue dans un interrupteur pendant une commutation étant égale au produit de la tension aux bornes de l'interrupteur par le courant le traversant et le temps de commutation. Il convient de distinguer les pertes de commutation à la fermeture et les pertes à l'ouverture d'un interrupteur. Dans un convertisseur fonctionnant selon un mode bidirectionnel tel qu'illustré par la figure 2, le problème des pertes de commutation à la fermeture des interrupteurs Tp, Ts est en principe résolu dans la mesure ou chaque fermeture d'interrupteur est précédée d'une période de conduction

2

de diode Dp, Ds garantissant une tension de fermeture proche de 0 (tension de diode). Par contre, chaque ouverture d'un interrupteur Tp, Ts provoque une réaction de l'élément inductif et une élévation brutale de la tension aux bornes de l'interrupteur, qui accroît le temps de commutation de l'interrupteur par effet Miller. Ce phénomène entraîne une perte d'énergie dans les interrupteurs d'autant plus sensible qu'elle se produit un grand nombre de fois par seconde quand la fréquence est élevée. De plus, l'élévation brutale de la tension à l'ouverture des interrupteurs se traduit par une émission de rayonnements électromagnétiques parasites. Les mêmes inconvénients se retrouvent dans un convertisseur à transformateur de type "fly-back", qui fonctionne selon le même principe.

Pour pallier cet inconvénient, on a proposé des convertisseurs à faibles pertes, dans lesquels les fronts de tension apparaissant à l'ouverture des interrupteurs primaire et secondaire sont adoucis grâce à l'ajout de capacités dites "de commutation douce".

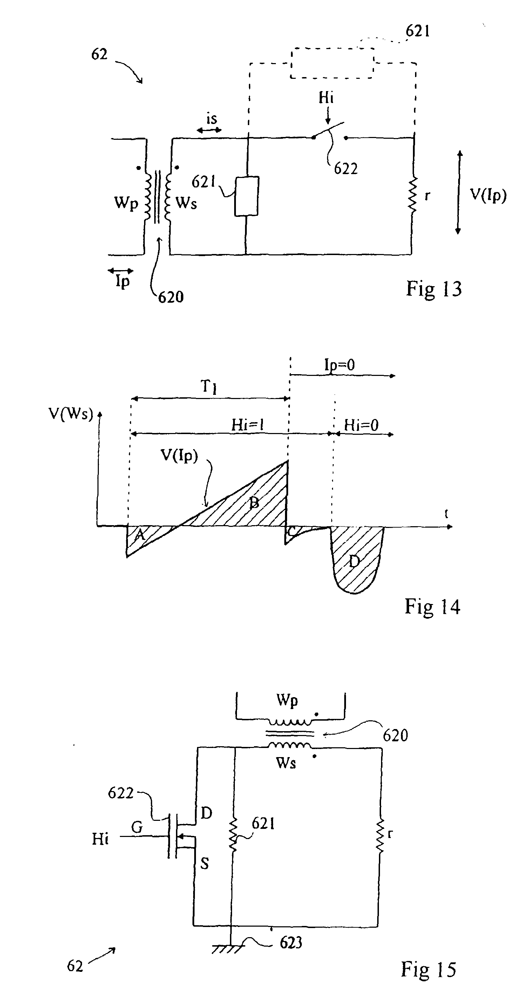

La figure 3 montre un convertisseur 10 à faibles pertes de type "fly-back". Ce convertisseur 10 s'apparente par exemple au convertisseur illustré en figure 15 de la demande de brevet européen 336 725. Il diffère du convertisseur de la figure 1 par l'ajout de deux capacités de commutation douce Cp, Cs, et par un mode de fonctionnement particulier faisant intervenir deux périodes de transitions qui seront décrites plus loin. La capacité Cp est ajoutée en parallèle à l'ensemble diode/interrupteur Dp/Tp du primaire et la capacité Cs en parallèle à l'ensemble diode/interrupteur Ds/Ts du secondaire. En outre, s'agissant ici d'un convertisseur "fly-back", l'inductance L de la figure 1 est remplacée par un transformateur 1 comprenant une inductance primaire Lp constituée d'un enroulement de Np spires, et une inductance secondaire Ls constituée d'un enroulement de Ns spires.

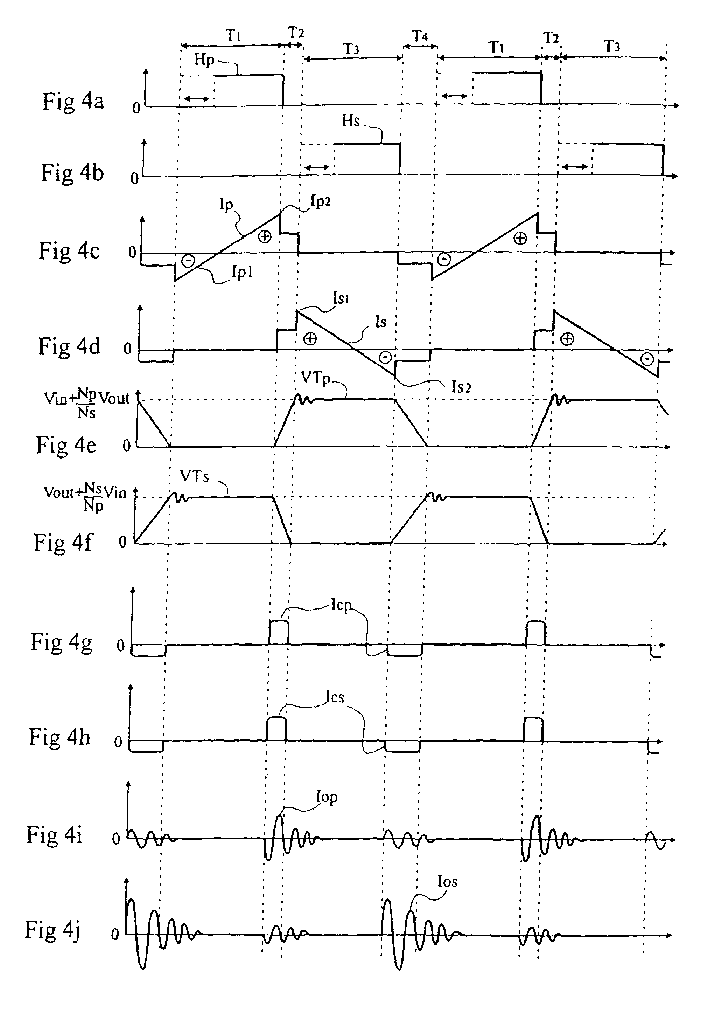

Le fonctionnement du convertisseur est illustré par la figure 4. Les figures 4a et 4b représentent des signaux de commande Hp et Hs appliqués respectivement aux interrupteurs Tp et Ts. Les figures 4c et 4d représentent les courants Ip et Is circulant respectivement dans les inductances primaire Lp et secondaire Ls du transformateur. Les figures 4e et 4f représentent des tensions VTp et VTs aux bornes des interrupteurs Tp et Ts. Les figures 4g et 4h représentent des courants de charge ou de décharge Icp et Ics des capacités Cp et Cs. Enfin, les figures 4i et 4j représentent des courants parasites Iop et Ios, qui s'ajoutent aux courants du primaire et du secondaire Ip et Is représentés en figures 4c et 4d.

Comme on le voit sur la figure 4, chaque cycle de fonctionnement du convertisseur 10 comprend quatre périodes distinctes que l'on désignera par leurs durées respectives T1, T2, T3, T4.

Les périodes T1 et T3 sont similaires aux périodes Ton et Toff précédemment décrites, à la différence près que les courants respectifs du primaire Ip et du secondaire Is traversent des enroulements Lp et Ls distincts. Ainsi, la période T1 comprend une phase de restitution côté primaire où le courant Ip est négatif (fig. 4c, diode Dp passante, Tp ouvert ou fermé), suivie d'une phase d'accumulation où le courant Ip est positif (diode Dp bloquée, Tp fermé, Hp = 1). De façon inverse, la période T3 comprend tout d'abord une phase de restitution côté secondaire où le courant Is est positif (diode Ds passante, Ts ouvert ou fermé) suivie d'une phase d'accumulation où le courant Is est négatif (fig. 4d, diode Ds bloquée, Ts fermé, Hs = 1). Comme représenté par des traits pointillées sur les figure 4a, 4b, il existe au cours des périodes T1 et T3 une marge de manoeuvre pour fermer les interrupteur Tp et Ts, tant que les diodes Dp et Ds sont passantes.

Les périodes T2 et T4 sont des périodes de transition de courtes durées au cours desquelles Tp et Ts sont maintenus ouverts. Sur la figure 4, T2 et T4 ne sont pas représentées à l'échelle et sont en réalité de l'ordre du dixième ou du centième de T1 et T3. Pendant ces périodes de transition, la capacité Cp se décharge et la capacité Cs se charge, et inversement (fig. 4g et 4h). Les diodes Dp, Ds sont dans l'état bloqué, l'énergie stockée dans le transformateur n'est transférée ni au primaire ni au secondaire.

L'homme du métier notera que les capacités de commutation douce Cp, Cs ne doivent pas être confondues avec les capacités que l'on trouve dans les convertisseurs dits à résonance, dont le principe de fonctionnement n'est pas comparable avec celui des convertisseurs à stockage inductif dont il est ici question. Ici, les capacités Cp, Cs ne sont pas des moyens permettant le transfert de l'énergie à travers le convertisseur. Elles sont au contraire choisies de manière à présenter des temps de charge ou de décharge T2 et T4 petits vis-à-vis des temps T1 et T3 pendant lesquels les transferts d'énergie se réalisent dans le convertisseur.

L'avantage d'ajouter des périodes de transition T2, T4 et de faire intervenir des capacités de commutation douce Cp, Cs est qu'à l'ouverture d'un interrupteur Tp ou Ts, la capacité Cp ou Cs associée à l'interrupteur se charge progressivement et empêche la montée brutale de la tension VTp ou VTs. Comme cela apparaît en figures 4e et 4f, la tension VTp ou VTs de l'interrupteur va croître pendant la période de transition T2 ou T4 jusqu'à atteindre sa valeur maximum, égale à Vin+Vout*Np/Ns pour VTp, et Vout+Vin*Ns/Np pour VTs. Les pertes de commutation à l'ouverture dues à l'effet Miller sont donc éliminées, ou du moins notablement réduites.

Ces convertisseurs présentent toutefois d'autres inconvénients, que l'on décrira maintenant.

## Inconvénients liés à l'utilisation de capacités de commutation douce

La demanderesse a tout d'abord remarqué que malgré l'adoucissement des fronts de montée/descente de VTp et VTs, les commutations des interrupteurs demeurent une source de rayonnement électromagnétique parasite. Plus particulièrement, on a constaté que ces rayonnements sont produits par des courants parasites lop, los dus à un phénomène d'oscillation parasite entre les capacités de commutation douce Cp, Cs et des inductances parasites présentes dans le convertisseur, que l'on peut représenter sous la forme d'une première inductance $Ip$ en série avec Lp et d'une deuxième inductance $Is$ en série avec Ls (fig. 3). Les courants lop et los, représentés en figures 4i et 4j, apparaissent après chaque commutation des interrupteurs Tp, Ts, suivent un régime oscillatoire qui s'amortit lentement, et présentent une intensité de crête pouvant égaler les valeurs maximum qu'atteignent Ip et Is à la fin de T1 et T3. Le courant lop circule dans l'ensemble de la boucle que constitue le circuit primaire, comprenant l'inductance Lp, le groupe diode/interrupteur/capacité Dp/Tp/Cp et la source de tension Vin, ainsi que les liaisons électriques entre ces éléments. De façon similaire, le courant los circule dans l'ensemble de la boucle que constitue le secondaire. Ainsi, chaque boucle primaire ou secondaire émet un rayonnement électromagnétique dû à un effet d'antenne, proportionnel à un flux magnétique $\Phi$ d'expression $\Phi = S*B$, $B$ représentant le champ magnétique créé par le courant parasite et S la surface de la boucle.

Un premier objet de la présente invention est d'atténuer l'effet de ces courants parasites, et de prévoir une structure de convertisseur à faible rayonnement.

Pour atteindre cet objet, la présente invention propose de modifier la disposition des capacités de commutation douce, et de les connecter en parallèle aux bornes de l'élément inductif du convertisseur. L'avantage est, d'une part, que la fonction de commutation douce des capacités est conservée, et, d'autre part, que les capacités de commutation douce forment, avec les inductances primaire et secondaire, des boucles de surfaces et de longueurs réduites dans lesquelles sont confinés les deux courant d'oscillation los, lop.

Ainsi, le flux magnétique $\Phi$ et le rayonnement parasite sont notablement diminués.

**Inconvénients des systèmes de commande classiques**

De façon générale, les tensions que délivrent les convertisseurs bidirectionnels sont stabilisées par l'intermédiaire d'un système de commande des interrupteurs primaire Tp et secondaire Ts, qui surveille en permanence la tension de sortie Vout et la compare à une tension de référence Vref. Le but recherché est de maintenir la tension de sortie Vout constante, en contrôlant les interrupteurs Tp et Ts et les durées T1 et T3 de conduction dans le primaire et le secondaire.

Dans un convertisseur en régime stabilisé, les temps T1 et T3 sont liés par une relation générale que l'on peut trouver de la façon suivante :

(a) pendant T1, la hauteur $\Delta Ip = Ip2\text{-}Ip1$ de la rampe de courant qui traverse l'enroulement primaire Lp a pour expression

$$(1) \qquad \Delta Ip = Vin*T1/Lp$$

Ip2 étant le courant positif en fin de période T1, Ip1 le courant négatif en début de période T1 (fig. 4c), Vin la tension d'entrée, et Lp l'inductance de l'enroulement primaire.

(b) de façon équivalente, pendant T3, la hauteur $\Delta Is = Is1\text{-}Is2$ (fig. 4d) de la rampe de courant traversant l'enroulement secondaire Ls a pour expression

$$(2) \qquad \Delta Is = Vout*T3/Ls$$

(c) le principe général de continuité de l'énergie E dans un transformateur permet d'écrire que l'énergie stockée à la fin d'une phase est égale à l'énergie transférée au début de la phase suivante. Cela se traduit par les égalités suivantes : $E = 1/2*Lp*(Ip2)^2 = 1/2*Ls*(Is1)^2$ pour le passage de T1 à T3, et $E = 1/2*Ls*(Is2)^2 = 1/2*Lp*(Ip1)^2$ pour le passage de T3 à T1. Comme par ailleurs, dans un transformateur, $Lp = Al*Np^2$ et $Ls = Al*Ns^2$, $Al$ étant une constante, on en déduit que

$$(4) \qquad Np*\Delta Ip = Ns*\Delta Is,$$

(d) en combinant cette dernière égalité avec les expressions (1) et (2) de $\Delta Ip$ et $\Delta Is$ données en (a), on en déduit que

$$(5) \qquad \frac{Vout}{Vin} = \frac{Ns}{Np} \frac{T1}{T3}$$

Cette relation donne le rapport qui existe entre la tension d'entrée Vin et la tension de sortie Vout, ce rapport étant supposé constant dans le cas d'un convertisseur en régime stabilisé. Bien entendu, cette relation concerne un convertisseur "fly-back" à transformateur : dans le cas d'un convertisseur "buck-boost", on prend Ns/Np = 1.

La relation (5) peut aussi s'écrire de la façon suivante :

$$(6) \qquad \frac{T3}{T1} = \frac{Ns}{Np} \frac{Vin}{Vout}$$

Ainsi, le rapport T3/T1 est toujours constant pour une tension de sortie Vout stabilisée et une tension d'entrée Vin constante, quelle que soit la méthode de commande mise en oeuvre.

Des exemples de systèmes de commande basés sur ce principe général de fonctionnement sont décrits dans la demande de brevet européen 336 725 précitée, en relation avec les figures 12, 14, 15 de cette demande. Selon l'art antérieur, il est connu de contrôler la durée de fermeture de l'interrupteur primaire Tp à partir d'un signal d'erreur ε élaboré par comparaison de la tension de sortie Vout et d'une tension de référence Vref. Egalement, il est connu de déclencher l'ouverture de l'interrupteur secondaire Ts (qui marque la fin de la période T3) lorsque le courant Is circulant dans le secondaire dépasse un certain seuil (contrôle du courant au secondaire), ou lorsque la tension de sortie Vout passe en dessous d'une certaine valeur.

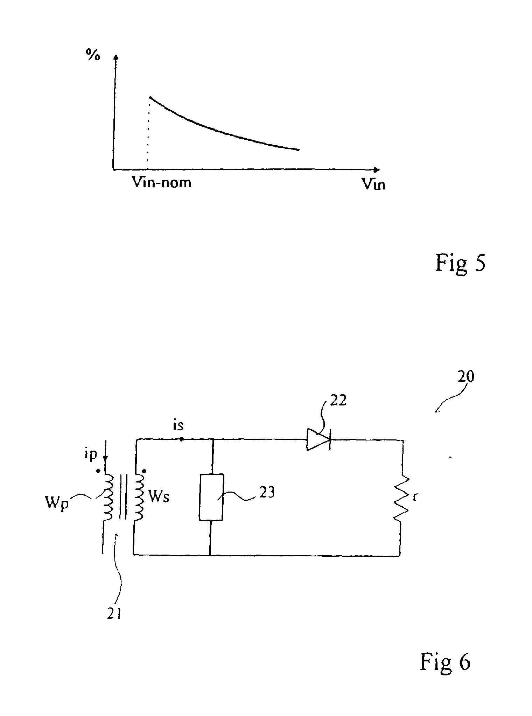

Un des inconvénients que présentent les systèmes de commande connus est de ne pas offrir un rendement optimal sur une large plage de valeurs de la tension d'entrée Vin. La figure 5 illustre la courbe du rendement en fonction des variations de la tension d'entrée d'un convertisseur commandé de manière classique. On voit que le rendement, optimum pour une valeur nominale de la tension d'entrée, se détériore lorsque Vin augmente. On attribue ce phénomène à une augmentation de l'amplitude des rampes de courants ΔIp, ΔIs dans le convertisseur et à des pertes par effet Joule. Cet inconvénient devient particulièrement gênant lorsque l'on ne dispose pas d'une source d'alimentation stable. Par exemple, dans le cas d'un aéronef, la tension nominale Vin distribuée par le réseau de l'aéronef est de l'ordre de 28V mais peut varier entre 12V et 36V ou plus jusqu'à 80V en cas de panne du réseau). Dans de telles conditions de fonctionnement, le rendement d'un convertisseur est difficile à maîtriser.

Un autre inconvénient de certains systèmes de commande connus est d'être basés à la fois sur une surveillance du courant primaire Ip et sur une surveillance du courant secondaire Is, et de nécessiter au moins deux capteurs de courant, l'un étant placé au primaire et l'autre au secondaire.

Un deuxième objet de la présente invention est de prévoir un système de commande d'un convertisseur bidirectionnel qui offi-e les avantages suivants :

- rendement optimal sur une large plage de valeurs de la tension d'entrée Vin, dans le cas d'une tension Vin non constante,
- possibilité de régler la tension de sortie Vout sur une large plage de valeurs tout en conservant un rendement optimal,
- surveillance du courant d'un seul côté du circuit, pour limiter le nombre de capteurs de courants. Ce sera de préférence le courant Ip côté primaire, pour des raisons pratiques : détection d'un éventuel problème de surcharge et contrôle du détachage à la mise sous tension,
- fonctionnement totalement symétrique : possibilité d'accepter en sortie une charge délivrant du courant.

**Inconvénients des capteurs de courant utilisés pour la surveillance des courants circulant dans un convertisseur de tension**

Comme indiqué plus haut, le contrôle d'un convertisseur nécessite une surveillance des courants circulant dans le convertisseur. Cette surveillance peut être réalisée par des capteurs de courant. Compte tenu des fréquences de fonctionnement élevées et des courants qui peuvent être importants, on recherche des capteurs de courant à faibles pertes présentant un temps de réponse court.

La figure 6 représente un capteur de courant 20 utilisé classiquement dans des convertisseurs de tension ou autres dispositifs similaires. Ce capteur de courant comprend un transformateur 21 qui présente un enroulement primaire Wp traversé par un courant ip à mesurer, et un enroulement secondaire Ws destiné à la mesure de ce courant. L'enroulement secondaire Ws est connecté, par l'intermédiaire d'une diode 22, à une résistance de mesure r. Enfin, une impédance 23 de démagnétisation du transformateur 21 (par exemple une diode zener ou une résistance de forte valeur) est connectée en parallèle aux bornes de Ws. Au cours d'une période de mesure, le courant ip traverse l'enroulement Wp et un courant is proportionnel à ip apparaît dans l'enroulement Ws, le rapport de proportionnalité entre ip et is étant déterminé par le rapport ns/np entre le nombre de spires de Ws et de Wp. Le courant is traverse la diode 22 et crée, aux bornes de la résistance de mesure r. une tension $V = r*is$ représentative du courant ip à mesurer. Cette période de mesure doit être nécessairement suivie d'une période de repos, où le courant ip doit être nul, pour que le transformateur 21 se démagnétise. Pendant la période de repos, la démagnétisation est assurée par l'impédance 23, aux bornes de laquelle apparaît une tension de polarité inversée. Sans période de repos, une tension d'erreur croissante apparaîtrait à la sortie du capteur de courant, due au stockage d'un courant magnétisant dans le transformateur 21 et à la saturation de celui-ci.

Le principal inconvénient de ce capteur de courant est qu'il ne peut détecter un courant que dans un seul sens, imposé par la diode 22. En outre, le noyau magnétique du capteur arrive très rapidement à la saturation lorsqu'un courant inverse au sens normal de détection traverse l'enroulement primaire Wp. Cela est particulièrement gênant lorsque l'on veut mesurer, dans un convertisseur bidirectionnel, les valeurs positives du courant primaire Ip. Le courant Ip étant négatif avant d'être positif, le capteur est d'abord traversé par un courant inverse au sens normal de détection, qui amène rapidement à la saturation le noyau magnétique du transformateur 21. Lorsque, ensuite, le courant Ip devient positif, la tension de sortie du capteur, au lieu d'être proportionnelle à Ip comme on pourrait s'y attendre, est en réalité entachée d'erreur.

Le document DE-A-3511710 décrit un capteur de courant comprenant un transformateur comportant un enroulement primaire et un enroulement secondaire l'enroulement primaire étant disposé dans un circuit susceptible d'être traversé par un courant à mesurer une impédance de démagnétisation du transformateur et une résistance de mesure reliée à l'enroulement secondaire capteur dans lequel la résistance de mesure est reliée à l'enroulement secondaire par l'intermédiaire d'un interrupteur, l'interrupteur est commandé de manière à être fermé quand un courant est susceptible de traverser l'enroulement primaire et ouvert pendant un laps de temps suffisant pour assurer la démagnétisation du transformateur quand aucun courant n'est susceptible de traverser l'enroulement primaire.

Un autre objet de la présente invention est de prévoir un capteur de courant isolé bidirectionnel. Un tel capteur pourra notamment mais non exclusivement être utilisé dans un convertisseur de tension bidirectionnel pour mesurer un courant susceptible de changer de polarité au cours d'une même période de mesure.

Pour atteindre cet objet la présente invention se base sur la constatation que dans un système commandé par des interrupteurs comme un convertisseur de tension bidirectionnel, il existe une relation entre la commande des interrupteurs et le passage du courant à mesurer dans une portion de circuit. Ainsi, la présente invention propose de remplacer la diode du capteur classique par un interrupteur commandé de manière à être fermé quand un courant à mesurer est susceptible de traverser l'enroulement primaire du capteur et de manière à être ouvert quand aucun courant n'est susceptible de traverser cet enroulement, afin d'assurer la démagnétisation du capteur.

La présente invention prévoit plus particulièrement un capteur de courant, fournissant la valeur signée d'un courant à mesurer et comprenant un transformateur comportant un enroulement primaire et un enroulement secondaire, l'enroulement primaire étant connecté pour être traversé par le courant à mesurer ; une impédance de démagnétisation du transformateur, connectée pour agir quelle que soit la polarité du courant fourni par l'enroulement secondaire ; une résistance de mesure dont une borne est directement connectée à une borne de l'enroulement secondaire ; un interrupteur bidirectionnel dont une borne est directement connectée à la seconde borne de l'enroulement secondaire, et dont la seconde borne est directement connectée à la seconde borne de la résistance de mesure ; et des moyens de commande dudit interrupteur pour fermer l'interrupteur quand un courant est susceptible de traverser l'enroulement primaire, et ouvrir l'interrupteur pendant un laps de temps suffisant pour assurer la démagnétisation du transformateur, quand aucun courant n'est susceptible de traverser l'enroulement primaire.

Avantageusement le capteur de courant est appliqué à la mesure d'un courant circulant par périodes dans un circuit, les périodes de circulation du courant étant contrôlées par des moyens de commande du circuit, un signal de commande de l'interrupteur du capteur étant élaboré par les moyens de commande du circuit pour que l'interrupteur soit fermé au moins pendant les périodes de circulation du courant et ouvert au moins pendant un laps de temps en dehors de ces périodes. Ce circuit peut être par exemple le circuit primaire d'un convertisseur de tension bidirectionnel.

Selon un mode de réalisation, l'impédance de démagnétisation est connectée en parallèle aux bornes de l'enroulement secondaire.

Selon un mode de réalisation, l'impédance de démagnétisation est connectée en parallèle aux bornes de l'interrupteur.

On décrira maintenant, à titre d'exemple non limitatif:

- des exemples de convertisseurs à faible rayonnement parasite, conformes au premier objet de la présente invention,

- un procédé de commande d'un convertisseur conforme au deuxième objet de la présente invention, ainsi que des exemples de réalisation de systèmes de commande selon ce procédé appliqués à un convertisseur à faibles pertes, et

- un capteur de courant selon la présente invention, utilisable notamment pour la détection d'un courant circulant dans un convertisseur bidirectionnel,

en relation avec les figures jointes, parmi lesquelles :

- la figure 1a représente le schéma électrique d'un convertisseur de tension bidirectionnel selon l'art antérieur, de type "buck-boost",
- les figures 1b à 1e sont des schémas électriques équivalents représentant le convertisseur de la figure 1 au cours de quatre phases de fonctionnement,
- la figure 2 est un diagramme de courant illustrant le fonctionnement du convertisseur de la figure 1a,
- la figure 3 représente le schéma électrique d'un convertisseur de tension bidirectionnel selon l'art antérieur, à faibles pertes et de type "fly-back",
- la figure 4 comprend des diagrammes 4a à 4j représentant des signaux électriques apparaissant en divers points du convertisseur de la figure 3,
- la figure 5 représente une courbe du rendement en fonction de la tension d'entrée des convertisseurs bidirectionnels selon l'art antérieur,
- la figure 6 représente le schéma électrique d'un capteur de courant selon l'art antérieur,
- la figure 7 représente le schéma électrique d'un convertisseur de tension bidirectionnel et, sous forme de blocs, un système de commande de ce convertisseur conforme à la présente invention,
- la figure 8 a pour but d'illustrer un procédé de commande de convertisseur bidirectionnel selon la présente invention, les diagrammes 8a, 8b, ..., 8e représentant des rampes de courant dans le circuit secondaire d'un convertisseur,
- les figures 9 et 10 sont des schémas électriques représentant de façon plus détaillée des blocs de la figure 7,
- la figure 11 représente des signaux électriques délivrés par le système de commande de la figure 7,

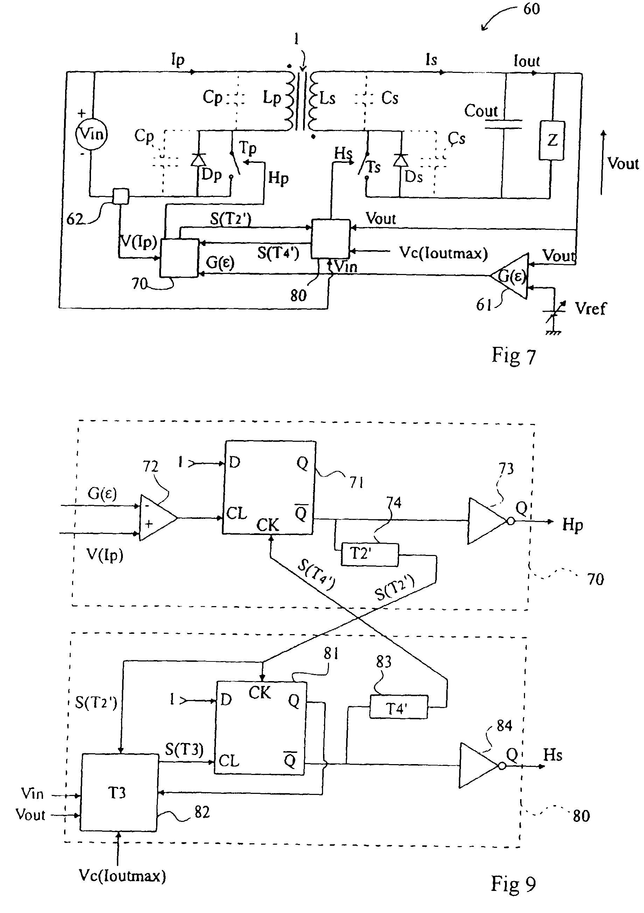

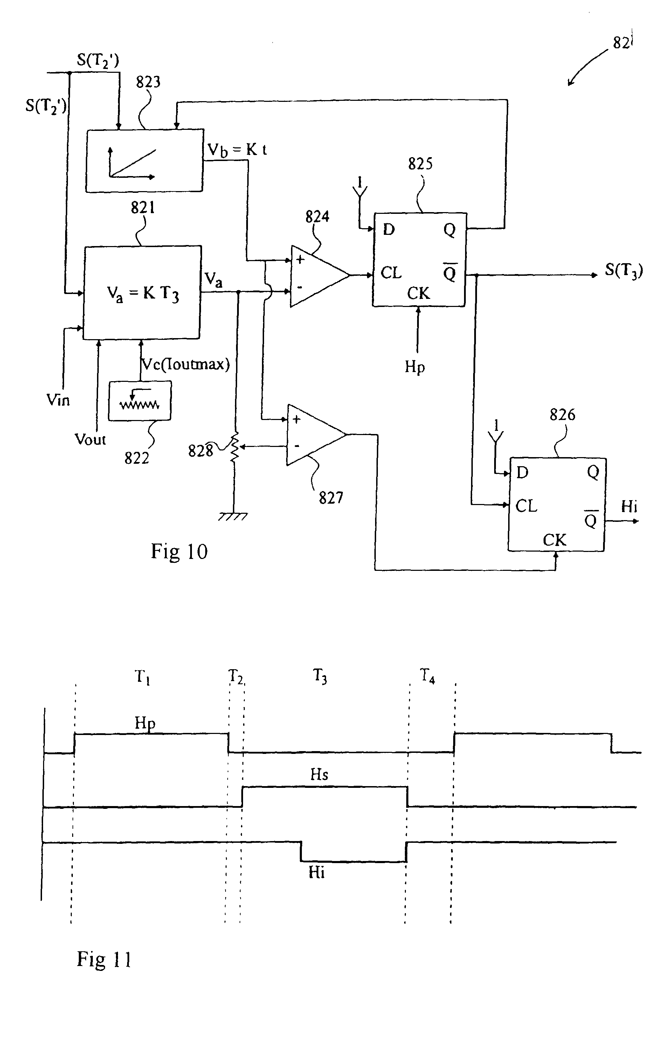

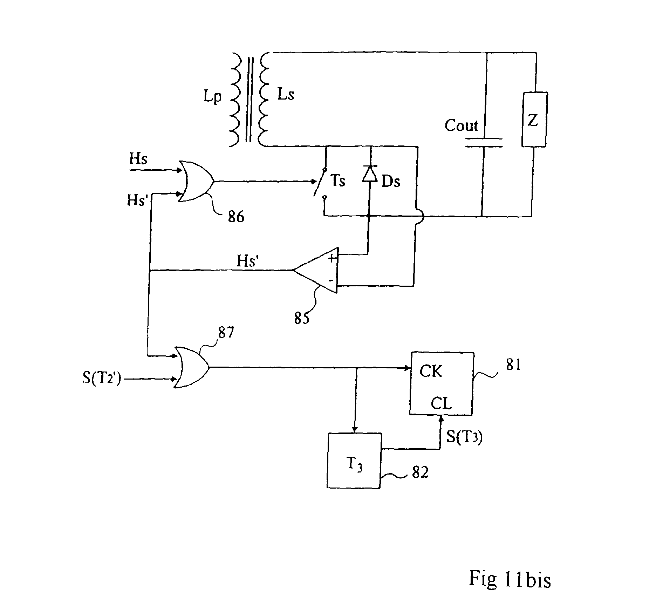

- la figure 11 bis représente un dispositif ajouté au convertisseur de la figure 7,

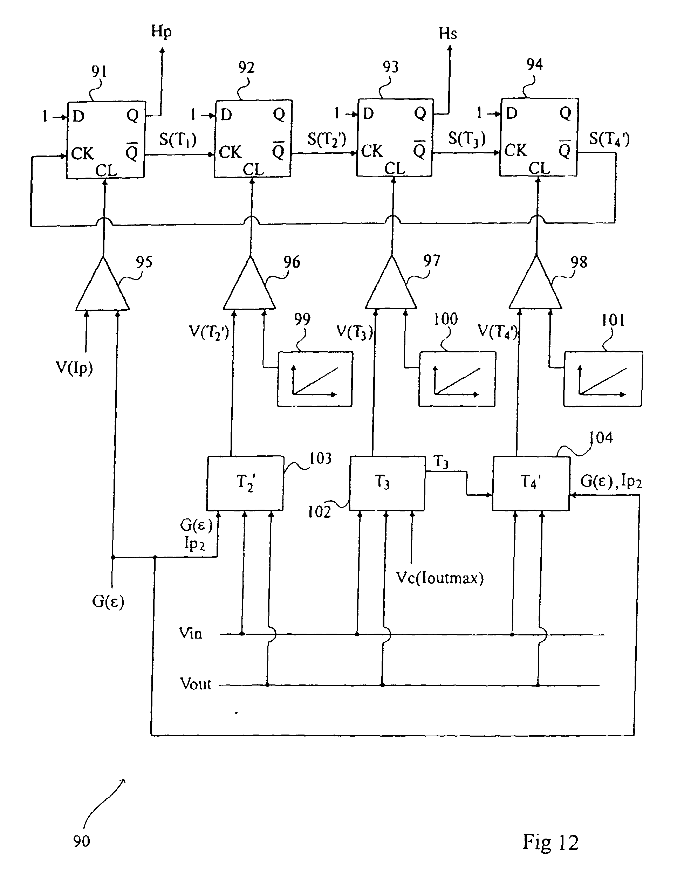

- la figure 12 représente une variante de réalisation du système de commande de la figure 7,
- la figure 13 représente le schéma électrique d'un capteur de courant selon la présente invention,
- la figure 14 illustre le fonctionnement du capteur de courant de la figure 13, et
- la figure 15 représente un mode de réalisation particulier du capteur de la figure 13.

La figure 7 représente un convertisseur 60 selon la présente invention, ici de type "fly-back". Dans sa structure, le convertisseur 60 ne diffère pas du convertisseur classique de la figure 3. On y retrouve tous les éléments déjà décrits, c'est-à-dire le transformateur 1 et les deux inductances Lp, Ls, les commutateurs primaire Dp/Tp et secondaire Ds/Ts, ainsi que la capacité de sortie Cout, la charge Z, et la source de tension Vin. Les capacités de commutation douce Cp, Cs peuvent être placées comme représenté en traits pointillés, c'est-à-dire de manière classique ou comme proposé précédemment.

Le convertisseur 60 est piloté par un système de commande selon l'invention qui comprend un amplificateur 61, un circuit 70 délivrant un signal Hp de commande de l'interrupteur primaire Tp, et un circuit 80 délivrant un signal Hs de commande de l'interrupteur secondaire Ts. L'amplificateur 61 est un amplificateur de boucle d'asservissement de type classique. Il reçoit en entrée la tension de sortie Vout du convertisseur 60 ainsi qu'une tension de référence réglable Vref, et délivre au circuit 70 une tension $G(\varepsilon)$ fonction de l'écart ou erreur $\varepsilon$ entre la tension Vout et la tension de référence Vref. Le circuit 70 reçoit en outre une tension V(Ip) représentative du courant Ip circulant dans le circuit primaire, délivrée par un capteur de courant 62 disposé en série avec le commutateur Dp/Tp.

Un cycle de fonctionnement du convertisseur 60 comprend les périodes T1, T2, T3, T4 déjà décrites au préambule en relation avec la figure 4. Le contrôle du convertisseur est assuré par le système de commande de la façon suivante. Pendant la période T1, l'interrupteur primaire Tp est fermé et Ts ouvert. Le circuit 70 compare V(Ip) à $G(\varepsilon)$ et ouvre l'inten-upteur Tp lorsque le courant Ip dans le primaire atteint une valeur telle que V(Ip) devient supérieure ou égale à $G(\varepsilon)$. Ainsi, le mode de commande choisi pour l'interrupteur primaire Tp, consiste à asservir le courant maximum Ip2 (fig. 4c) de la rampe de courant dans le circuit primaire. L'ouverture de Tp, qui correspond à la fin de la période T1, provoque le début de la période T2, où Tp et Ts sont laissés ouverts. A la fin de T2, le circuit 70 envoie au circuit 80 un signal S(T2'). Selon l'invention, lorsque le circuit reçoit le signal S(T2'), il ferme l'interrupteur Ts du secondaire et compte un temps T3. Lorsque le comptage de T3 est terminé, le circuit 80 ouvre l'interrupteur Ts, ce qui correspond au début de la période T4. A la fin de T4, le circuit 80 envoie un signal S(T4') de fin de période T4 au circuit 70, qui va alors déclencher le cycle suivant en fermant Tp. Après une période de démarrage suivant la mise sous tension du convertisseur, Vout se stabilise à une valeur proche de Vref. On peut ainsi choisir la tension de sortie par un réglage approprié de Vref.

Une caractéristique remarquable de la présente invention qui apparaît dans la description ci-dessus du système de commande, est que l'ouverture du transistor secondaire Ts est déterminée uniquement par un comptage du temps T3. De plus, selon l'invention, le temps T3 n'est pas fixé arbitrairement, mais déterminé par une relation qui conduit aux avantages recherchés. On décrira maintenant une méthode permettant de déterminer T3.

La présente invention prévoit tout d'abord de rechercher une relation permettant d'exprimer T3 sous la forme suivante :

$$T3 = f(Vin, Vout, Ioutmax),$$

Vin étant la tension d'entrée du convertisseur, Vout la tension de sortie et Ioutmax une valeur maximum du courant Iout susceptible d'être débité par le convertisseur dans la charge Z, ou reçu de la charge Z (fig. 11). Le fonctionnement étant bidirectionnel, ce courant peut être en effet être positif (+Ioutmax) ou négatif (-Ioutmax).

On rappelle préalablement que les relations générales (2) et (6) décrites au préambule, relatives à la hauteur $\Delta$Is de la rampe du courant Is dans le secondaire (fig. 4d) et au rapport entre T3 et T1, sont les suivantes :

$$(2) \qquad \Delta Is = Is1\text{-}Is2 = Vout*T3/Ls,$$

et

$$(6) \qquad \frac{T3}{T1} = \frac{Ns\ Vin}{Np\ Vout}$$

Le courant Is dans le secondaire ayant la forme d'une rampe de hauteur $\Delta$Is (fig. 4d), le courant moyen de sortie Iout débité par le convertisseur peut s'exprimer ainsi :

$$(7) \qquad Iout = 1/2(Is1+Is2)*T3/(T1+T3),$$

en négligeant T2 et T4 qui devraient être ajoutés à T1 et T3 au dénominateur. Par ailleurs, la rampe de courant $\Delta$Is traversant le secondaire ne doit pas être quelconque, et peut être définie à partir des impératifs suivants :

- (A) si l'on veut qu'il y ait commutation douce à la fermeture des interrupteurs, il faut qu'à chaque cycle les diodes Dp et Ds soient passantes avant la fermeture des interrupteurs, au moins pendant un instant très court. Cela signifie qu'il doit y avoir une période d'inversion du sens du courant Is. En d'autres termes, Is1 doit toujours être positif, même si Is1 est très proche de 0, et Is2 toujours négatif, même si Is2 est très proche de 0,
- (B) si l'on veut garantir un rendement optimum et homogène en limitant les pertes par effet Joule ainsi que les pertes fer, il faut que la hauteur $\Delta$Is de la rampe de courant Is soit maîtrisée et contenue dans un certain gabarit,
- (C) une manière simple d'obtenir le résultat visé en (B) consiste à rechercher un mode de commande garantissant que la hauteur de rampe $\Delta$Is soit une constante indépendante du courant de sortie Iout, pour des valeurs de Vin, Vout constantes.

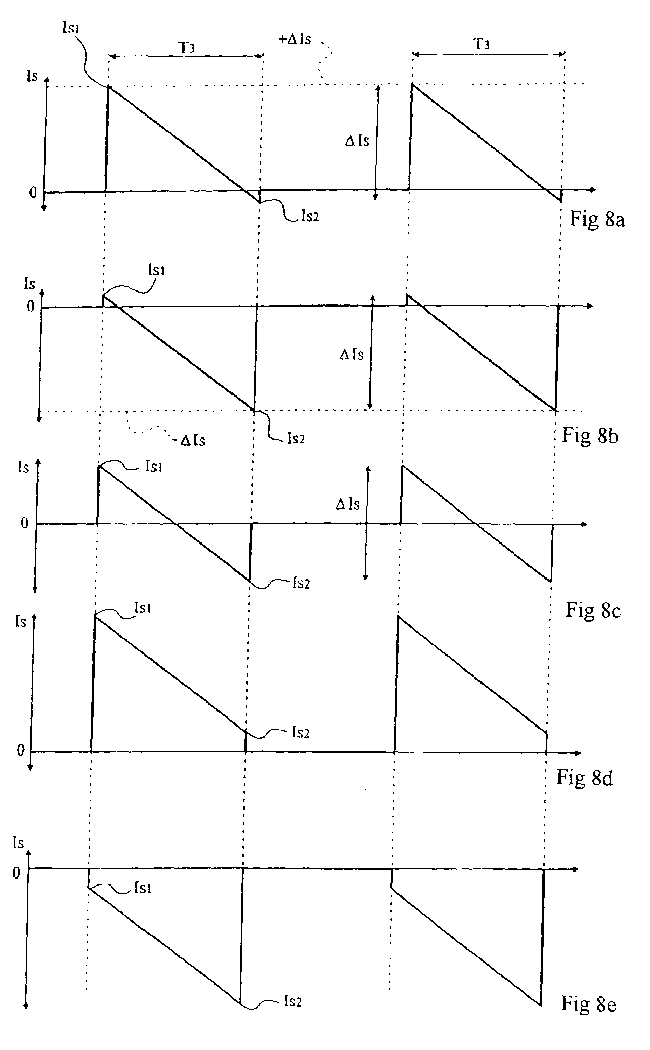

A partir des trois conditions (A), (B), (C) on peut définir la forme de la rampe $\Delta$Is comme représenté sur les diagrammes de la figure 8. En figure 8(a) on a représenté un cas extrême qui correspond à un courant de sortie Iout maximum (Iout = +Ioutmax, charge maximum en sortie). Dans ce cas, Is2 est quasiment nul mais négatif, le courant Is1 atteint la limite supérieure d'un gabarit délimité par des valeurs +$\Delta$Is et -$\Delta$Is, et on voit que Is1 = +$\Delta$Is. En figure 8 (b) un autre cas extrême et inverse du premier est représenté, celui d'une charge Z qui restitue de l'énergie dans le convertisseur (Iout = -Iout max). Is1 est quasiment nul mais positif, Is2 atteint la limite inférieure du gabarit et Is2 = -$\Delta$Is. En figure 8(c) est représenté un cas moyen où la rampe de courant $\Delta$Is (qui est constante conformément à l'hypothèse (C)) se situe dans la partie médiane du gabarit. Dans ce dernier cas, le courant de sortie Iout est nul (pas de charge en sortie). Les figures 8d et 8e, qui ne sont données que pour fixer les idées, montrent des formes de rampes de courant Is entièrement positives ou entièrement négatives que la présente invention cherche à éviter, conformément à la condition (A). Si le cas des figures 8d et 8e se réalisait, il n'y aurait pas de phases de conduction des diodes Dp et Ds et pas de commutation douce à la fermeture des interrupteurs Tp, Ts.

$\Delta$Is étant maintenant définie, on voit que lorsque le courant de sortie Iout est maximum (Iout Ioutmax, figure 8a), on peut écrire

$$(8) \qquad \Delta Is = Is1$$

Par ailleurs, toujours dans le cas où le courant de sortie Iout est maximum, la relation (7) devient

$$(9) \qquad Iout = Ioutmax = 1/2*Is1*(T3/(T1 + T3))$$

En combinant les relations (8) et (9), il vient

$$(10) \qquad Ioutmax = 1/2*\Delta Is*(T3/(T1 + T3))$$

En combinant la relation (6) et la relation (10), il vient

$$(11) \qquad Ioutmax = 1/2*\Delta Is*[(Nsp*Vin)/(Vout+(Nsp*Vin))],$$

Nsp représentant le rapport Ns/Np.
En combinant la relation (11) et la relation (2), il vient

$$(12) \qquad T3 = 2\ [Ioutmax*Ls/Vout]*[(Vout+Nsp*Vin)/(Nsp*Vin)].$$

On obtient ainsi la relation T3 = f (Vout, Vin, Ioutmax) recherchée, réalisée par le circuit 80 de la figure 10. Les paramètres Ls et Nsp étant des constantes, ils sont pris en compte dans la constitution du circuit 80. Les paramètres Vin, Vout et la consigne Ioutmax étant des variables, la relation (12) peut être mise en oeuvre selon les options décrites ci-après.

Une première option consiste à calculer T3 à partir de deux paramètres fixes Vin# et Vout#, Vin# étant pris égal à la tension minimale que la source de tension d'alimentation Vin est supposée délivrer, Vout# étant pris égal à la tension de référence Vref de l'asservissement. Dans ce cas, le circuit 80 est "aveugle" et ne connaît pas les conditions réelles de fonctionnement du convertisseur. Le convertisseur fonctionnera toutefois de manière satisfaisante si la tension d'entrée Vin ne varie pas selon une plage de valeurs trop étendue.

Une deuxième option consiste à calculer T3 à partir du paramètre Vout# et la valeur réelle de Vin prélevée en entrée du convertisseur. Dans ce cas, le circuit 80 est capable de s'adapter à des fluctuations importantes de Vin tout en gardant un rendement optimum.

Une troisième option consiste à calculer T3 à partir des valeurs réelles de Vin et Vout, prélevées à l'entrée et à la sortie du convertisseur. Dans ce cas, le convertisseur fonctionne de manière auto adaptative, le rendement restant optimal même en cas de fluctuations importantes de Vin ou de modification de la consigne Vref qui détermine Vout.

La figure 9 représente un exemple de réalisation des circuits 70 et 80 selon la troisième option.

Le circuit 70 comprend une bascule logique 71 de type bascule D, et un comparateur 72 recevant sur son entrée positive le signal V(Ip) et sur son entrée négative le signal G(ε). L'entrée D de la bascule 71 est maintenue à 1, l'entrée CL de remise à zéro de la bascule reçoit la sortie du comparateur 72, et l'entrée d'horloge CK reçoit le signal S(T4') délivré par le circuit 80. Le signal de commande Hp de l'interrupteur Tp est délivré par une cellule inverseuse 73 recevant en entrée la sortie inverse /Q de la bascule. La sortie /Q est également appliquée en entrée d'une ligne à retard 74 délivrant le signal S(T2'). La ligne à retard 74 recopie sur sa sortie, avec un retard T2', le signal reçu sur son entrée.

Le circuit 80 comprend une bascule D 81 et un circuit 82, réalisant le calcul de T3 selon la relation (12) et délivrant un signal S(T3) lorsque T3 est expiré A cet effet, le circuit 82 reçoit en entrée la tension d'entrée Vin, la tension de sortie Vout, et une tension de consigne Vc représentant la consigne de courant Ioutmax. Le circuit 82 reçoit également en entrée le signal S(T2') délivré par le circuit 70, et la sortie Q de la bascule 81. Enfin, la bascule 81 est agencée de la façon suivante. L'entrée D est maintenue à 1, l'entrée CL reçoit le signal S(T3) envoyé par le circuit 82, l'entrée d'horloge CK reçoit le signal S(T2'). La sortie inverse /Q est appliquée à une ligne à retard 83 de retard T4' qui délivre S(T4'), ainsi qu'à une cellule inverseuse 84 qui délivre le signal Hs de commande de l'interrupteur Ts.

Les circuits 70 et 80 fonctionnent comme suit. A la réception d'un front montant du signal S(T4'), la bascule D 71 recopie sur sa sortie Q l'entrée D qui est à 1. La sortie /Q passe à 0 et Hp passe à 1, ce qui provoque la fermeture de l'interrupteur Tp. Lorsque le courant Ip dans le convertisseur est tel que V(Ip) devient supérieur à G(ε), la sortie du comparateur 72 passe à 1 et la sortie Q de la bascule 71 est remise à 0. La sortie /Q passe à 1, l'interrupteur Tp s'ouvre.

Cela marque la fin de la période T1. Le front montant de tension apparu sur /Q à l'instant du passage à 1 traverse la ligne à retard 74 et atteint avec un retard T2' l'entrée CK de la bascule 81 ainsi que le circuit 82. Ce front montant est le signal S(T2'). La sortie /Q de la bascule 81 passe à 0, le signal Hs passe à 1 (l'interrupteur Ts se ferme) et le circuit 82 commence le comptage de T3. Lorsque le temps T3 est écoulé, le circuit 82 délivre un front montant sur sa sortie S(T3). La bascule 81 est remise à 0, Hs passe à 0 et l'interrupteur Ts s'ouvre. C'est la fin de la période T3. Un front montant de tension issu de la sortie /Q de la bascule 81 se propage dans la ligne à retard 83 jusqu'à atteindre la bascule 71 avec un retard T4'. Ce front montant correspond au signal S(T4') et provoque le démarrage d'un nouveau cycle.

Un exemple de réalisation du circuit 82 est illustré par la figure 10. A la réception d'un front montant de S(T2'), un circuit 821 calcule le temps T3 selon la relation (12) et reçoit à cet effet sur ses entrées Vin, Vout, et la consigne Vc (Ioutmax). Il délivre un tension fixe Va égale à K*T3, K étant une constante Un front montant de S(T2') déclenche également dans un circuit 823 l'élaboration d'un rampe de tension Vb égale à K*t, t représentant le temps. Va et Vb sont comparées dans un comparateur 824 dont la sortie attaque l'entrée CL de remise à zéro d'une bascule D 825, dont l'entrée D est maintenue à 1 et l'entrée d'horloge CK reçoit le signal Hp (équivalent à la sortie Q de la bascule 71 du circuit 70). La sortie inverse /Q de la bascule 825 délivre le signal S(T3) et la sortie Q est appliquée au circuit 823 pour la remise à zéro de la rampe Vb.

On ne décrira pas plus en détail ces divers circuits dont la réalisation est à la portée de l'homme du métier. En particulier, le circuit 821 qui calcule T3 selon la relation (12) peut être réalisé de façon classique, au moyen de multiplieurs et de diviseurs de tension.

Dans le système de commande qui vient d'être décrit, on peut prévoir que la consigne Vc (Ioutmax) donnée au circuit 821 soit choisie par l'utilisateur, qui pourra ainsi calibrer le convertisseur en fonction de l'application envisagée. Par exemple, si l'on sait que la charge consommera peu de courant (Iout), il est avantageux de régler Vc à une valeur basse pour que le rendement du convertisseur soit le meilleur. La relation (11) ci-dessus montre en effet que la diminution de la consigne Ioutmax correspond à une diminution de la rampe $\Delta$Is et, par conséquent, une diminution des peltes par effet Joule dans le convertisseur. La solution montrée sur la figure 10 consiste à régler Vc au moyen d'un potentiomètre 822.

Si l'on se réfère maintenant aux diagrammes 4c et 4d de la figure 4, on voit que les durées des périodes T2 et T4 sont déterminées par les temps de charge ou décharge des capacités de configuration douce Cp et Cs, alors que T2' et T4' sont des temps déterminés par les circuits 70 et 80. Dans l'exemple de réalisation qui vient d'être décrit, T2' et T4' sont déterminés par les lignes à retard 74 et 83, et seront de préférence choisis en tenant compte des précautions suivantes :

- T2' et T4' doivent être sensiblement supérieurs à T2 et T4 pour que les diodes Dp ou Ds soient dans l'état passant avant que les interrupteurs Tp ou Ts ne se ferment, et dans le but d'éviter des pertes de commutation à la fenneture,
- d'autre part, T2' et T4' doivent être très proches de T2 et T4, pour que les interrupteurs Tp ou Ts soient fermés au plus tôt après l'entrée en conduction de la diode à laquelle ils sont associés, Dp ou Ds. Cette précaution permet de faire passer prioritairement le courant dans les interrupteurs et de diminuer ainsi les pertes par effet Joule en améliorant encore plus le rendement, les tensions d'interrupteurs, de l'ordre de 0.2 à 0.3 V dans le cas d'interrupteurs MOS, étant inférieures aux tensions de diodes, de l'ordre de 0.6 à 1V.

En pratique, pour choisir T2' et T4', on peut faire une estimation préalable de T2 et T4 à partir des relations suivantes :

$$(13) \qquad T2 = \frac{\text{Vin+NpsVout}}{\text{Ip2}}\ (Cp+Nsp^2Cs)$$

$$(14) \qquad T4 = \frac{\text{NspVin+Vout}}{\text{-Is2}}\ (Nsp^2Cp+Cs)$$

dans lesquelles Nsp représente le rapport Ns/Np et Nps le rapport Np/Ns.

Un inconvénient pourrait toutefois apparaître dans certaines conditions de fonctionnement, notamment dans le cas où de grandes variations de la tension d'entrée Vin sont susceptibles de se produire, ou lorsque l'on modifié fortement la tension de sortie Vout par un réglage approprié de Vref. Dans de telles conditionné d'utilisation, il peut être difficile de trouver des valeurs fixes de T2'et T4' qui soient satisfaisantes en toutes circonstances, puisque les valeurs réelles T2 et T4, définies par les relations (13) et (14), dépendent de Vin et Vout et sont susceptibles de varier.

Une première solution pour pallier les risques liés à un décalage trop important entre T2', T4' et les valeurs vraies T2, T4 imposées par les conditions de fonctionnement du convertisseur est illustrée par la figure 11bis. Dans un souci de simplicité, on n'a représenté sur la figure 14bis que le côté secondaire du convertisseur 60. Un comparateur 85 dont l'entrée positive est connectée à l'anode et l'entrée négative à la cathode de la diode Ds, délivre un signal Hs'. Ce signal Hs' est superposé au signal normal Hs de commande de l'interrupteur secondaire Ts grâce à une porte logique 86 de type OU dont la sortie commande l'interrupteur Ts. Lorsque la période "vraie" T2 se termine, la tension aux bornes de la diode Ds s'inverse et Ds devient passante. La tension aux bornes de Ds, bien que proche de 0 (de -0.6 à -1V), est suffisante pour déclencher le comparateur 85 dont la sortie IIs' passe à 1. Ainsi, quand Ds devient passante, Hs' assure de façon anticipée la fermeture de Ts si Hs n'est pas encore à 1. Bien entendu, un dispositif équivalent peut être ajouté dans le circuit primaire, pour assurer la fermeture anticipée de Tp. En outre, comme montré sur la figure 11bis, le signal Hs' peut être superposé au signal S(T2') au moyen d'une porte logique OU 87, dont la sortie remplace le signal S(T2') et attaque la bascule Q 81 et le circuit 82 précédemment décrits. Ce dispositif permet de synchroniser le démarrage du calcul de T3 à la fenneture anticipée de Ts. On notera toutefois qu'en règle générale ces questions de synchronisation pour le calcul de T3 ne sont pas d'une très grande importance pratique, puisque les temps T2, T2', T4, T4', de l'ordre de la centaine de nanosecondes, sont très courts devant T1 et T3, de l'ordre de la microseconde. Ainsi, un décalage de quelque dizaines de nanosecondes entre T2' et T2 ou T4' et T4 serait insignifiant devant la durée de T1 ou T3.

Comme alternative à la solution ci-dessus décrite, la présente invention prévoit une méthode qui consiste à remplacer les lignes à retards 74 et 83 de la figure 9 par des circuits calculant en temps réel T2' et T3' suivant les relation (13) et (14) données ci-dessus. Dans la relation (13), on voit que les trois paramètres nécessaires pour le calcul de T2' sont Vin et Vout, déjà utilisés pour le calcul de T3, ainsi que Ip2. Grâce au mode de commande de la fermeture de l'interrupteur primaure Tp prévu par l'invention, Ip2 est donné par l'égalité V(Ip2)= G($\varepsilon$) (passage à 1 du comparateur 72 de la figure 12, marquant la fin de la période T1). Ainsi, tous les paramètres permettant de calculer T2' sont disponibles. En ce qui concerne le calcul de T4', on voit que la relation (14) dépend du courant Is2, qui est le courant maximum négatif circulant dans le secondaire à la fin de la période T3. On ne souhaite pas mesurer le courant Is2 au secondaire, mais connue $\Delta$Is = Is1 - Is2, il vient

$$(15) \qquad Is2 = Is1 - \Delta Is$$

Or, $\Delta$Is est donné par la relation (2)

$$(2) \qquad \Delta Is = Is1 - Is2 = Vout*T3/Ls,$$

Vout et T3 étant connus et Ls étant une constante.

De plus, Is1 est donné par la relation suivante

$$(16) \qquad Is1 = NpsIp2,$$

Ip2 étant connu et Nps étant une constante.

Ainsi, T4' peut être également défini au moyen de la relation (14), à partir des paramètres Vin, Vout, Ip2, T3, qui sont connus.

La figure 12 représente de façon simplifiée un mode de réalisation d'un système de commande 90 dans lequel T2', T3, et T4' sont détenninés par calcul. Le système de commande 90 représente l'équivalent des circuits 70 et 80 de la figure 10. Il comprend quatre bascules D en cascade, respectivement 91, 92, 93, 94, ayant chacune leur entrée D maintenue à 1. La sortie inverse /Q de la première bascule 91 délivre un signal S(T1) de fin de période T1 et attaque l'entrée d'horloge CK de la bascule 92. La sortie /Q de la bascule 92 délivre S(T2') et attaque l'entrée CK de la bascule 93 dont la sortie /Q délivre S(T3) et attaque l'entrée CK de la bascule dernière 94. Enfin, la sortie /Q de la bascule 94 délivre S(T4') qui est ramené sur l'entrée CK de la première bascule 91. Par ailleurs, la sortie Q de la première bascule délivre le signal de commande Hp et la sortie Q de la troisième bascule 93 le signal de commande Hs. Chaque entrée CL de remise à zéro des bascules 91, 92, 93, 94 est attaquée par la sortie d'un comparateur, respectivement 95, 96, 97, 98. Le comparateur 95 reçoit sur ses entrées la tension V(Ip) et le signal d'asservissement G($\varepsilon$), conformément à la méthode de commande de la fermeture de Tp déjà décrite. Le comparateur 96 compare une tension V(T2') représentative de T2' à une rampe de tension délivrée par un circuit 99. Le comparateur 97 compare une tension V(T3) représentative de T3 à une rampe de tension délivrée par un circuit 100. Enfin, le comparateur 98 compare une tension V(T4') représentative de T4' à une rampe de tension délivrée par un circuit 101. La tension V(T3) est délivrée par un circuit 102 semblable au circuit 821 de la figure 13. La tension V(T2') est délivrée par un circuit 103 qui réalise la relation (13) donnée précédemment, et la tension V(T4') par un circuit 104 qui réalise la relation (14). A cet effet, le circuit 103 reçoit en entrée Vin, Vout et Ip2 (c'est-à-dire G($\varepsilon$)), et le circuit 104 reçoit Vin, Vout, Ip2 et T3, ce dernier paramètre étant donné par le circuit 102. Le fonctionnement du système suit le même principe que celui décrit précédemment, à la différence que T2' et T4' sont obtenus par calcul. L'avantage est qu'en cas de grandes variations de la tension d'entrée Vin ou d'une modification substantielle de la tension de sortie Vout, le système de commande selon l'invention va s'adapter aux nouvelles conditions de fonctionnement en calculant des valeurs T2', T4' très proches de T2 et T4.

L'homme du métier notera que le système de commande 90 selon l'invention peut faire l'objet de nombreux autres perfectionnements. En particulier, un perfectionnement consiste à rendre encore plus précises les diverses relations qui président à la commande des interrupteurs. Par exemple, dans la relation (7) donnée plus haut, on n'a pas tenu compte de T2 et T4, alors que cette relation pouvait être exprimée ainsi :

$$(17) \qquad Iout = 1/2(Is1+Is2)*T3/(T1+T2+T3+T4)$$

En injectant dans la relation (17) les expressions de T2 et T4 données par les relations (13) et (14), on obtient une expression de T3 plus complète qui peut, comme la relation (12), être réalisée au moyen d'un circuit électronique.

Par ailleurs, le système de commande selon l'invention peut être simplifié, si l'on vise des applications à faible coût où le rendement du convertisseur a une moindre importance. On peut alors supprimer les capacités de commutation douce Cp et Cs, et s'arranger pour que les temps T2' et T4' soient proches de 0. Dans le mode de réalisation de la figure 12, cela se traduirait par la suppression des lignes à retard 74 et 83. Le convertisseur présentera des pertes de commutation plus élevées, mais offrira l'avantage d'une réalisation plus simple tout en acceptant des variations importantes de Vin et la possibilité de régler Vout selon une large plage de valeurs. Comme variante de réalisation, on peut utiliser les capacités parasites des transistors MOS comme capacités de commutation douce.

L'homme du métier notera également que le procédé et le système de commande qui viennent d'être décrit ne s'appliquent pas spécifiquement à un convertisseur de type "fly-back" comme celui de la figure 7, mais concernent de façon générale tout convertisseur bidirectionnel à transfert de charge.

Dans le cas d'un convertisseur "buck-boost" les relations données ci-dessus sont applicables à condition bien entendu de considérer que Ns/Np = 1. Dans le cas d'un convertisseur à sorties multiples une variante de réalisation consiste à ajouter des interrupteurs secondaires dans les circuits secondaires et à les commander conjointement à l'interrupteur du circuit secondaire, comme si le secondaire, convertisseur ne comportait qu'un seul interrupteur.

On décrira maintenant le capteur 62 de la figure 7.

## Capteur de courant bidirectionnel

La figure 13 représente le capteur de courant 62 selon la présente invention. Le capteur 62 comprend, de façon classique, un transformateur 620 comprenant un enroulement primaire Wp dans lequel circule le courant Ip à mesurer, un enroulement secondaire Ws, une résistance de mesure r, et une impédance de démagnétisation 621, par exemple une résistance de grande valeur ou une diode zener. De façon classique, le capteur délivre une tension de sortie V(Ip) égale à r*is, is étant le courant secondaire dans l'enroulement Ws. Selon l'invention, un interrupteur 622 commandé par un signal Hi est placé entre la résistance r et l'enroulement Ws. Ainsi, quand le courant à mesurer Ip change de polarité dans l'enroulement primaire Wp, l'interrupteur 622, s'il est fermé, ne s'oppose pas au changement de polarité du courant secondaire is, et la polarité de la tension de sortie V(Ip) s'inverse. Le capteur selon l'invention présente donc l'avantage d'être bidirectionnel. Un autre avantage est que le risque d'une magnétisation rapide du noyau magnétique du transformateur 620 est écarté, puisque quel que soit le sens du courant dans l'enroulement primaire Wp, un courant peut circuler dans l'enroulement secondaire Ws. Cet avantage suppose bien entendu que la commande Hi soit élaborée de manière que l'interrupteur 622 soit toujours fermé quand un courant traverse l'enroulement primaire Wp. En ce qui concerne la disposition de l'impédance 621 dans le capteur, on notera que celle-ci peut être connectée aux bornes de l'enroulement Ws, ou bien aux bornes de l'interrupteur 622 comme représenté en traits pointillés sur la figure 13.

Malgré la diminution des risques de saturation rapide, le capteur 62 nécessite néanmoins une période de repos pour que le transformateur 620 se démagnétise. Au cours de cette période de repos, l'interrupteur 622 doit être ouvert et aucun courant ne doit circuler dans l'enroulement primaire Wp. Cette caractéristique du capteur sera mieux comprise en décrivant maintenant un procédé de commande de l'interrupteur 622, en relation avec la figure 14.

La figure 14 représente la tension V(Ws) aux bornes de l'enroulement secondaire Ws au cours d'un cycle de fonctionnement du convertisseur de la figure 7. Pendant la période T1, l'interrupteur 622 est fermé (Hi = 1), la tension V(Ws) est égale à la tension de sortie V(Ip) du capteur. V(Ip) recopie le courant Ip et a la forme d'une rampe, d'abord négative (A) quand Ip est négatif, puis positive (B) lorsque Ip est positif. Lorsque Ip s'annule (fin de la période T1), la tension V(Ip) passe à 0, mais il subsiste dans l'enroulement Ws un courant de magnétisation apparu dans le transformateur 620 pendant la phase de mesure. Si l'interrupteur 622 est maintenu fermé, ce courant de magnétisation traverse la résistance r, et crée aux bornes de Ws une tension de démagnétisation négative et décroissante de faible intensité (C). Sur la figure 13, la référence "A" représente l'aire (en Volts secondes) de la partie négative de la rampe de tension due au courant Ip négatif, "B" représente l'aire de la rampe de tension due au courant Ip positif, et "C" l'aire de la tension de démagnétisation. En raison des propriétés des transformateurs, si on laisse l'interrupteur 622 fermé, la démagnétisation du capteur sera atteinte lorsque

$$C = B - A,$$

c'est-à-dire lorsque les aires positive et négatives des tensions apparues aux bornes de l'enroulement secondaire, se seront mutuellement annulées. Le courant de démagnétisation étant faible et décroissant, l'aire "C" croît très lentement. Si l'interrupteur 622 est laissé dans l'état fermé, le transformateur 620 risque de n'être pas entièrement démagnétisé au commencement du cycle suivant (T1). Il est donc préférable d'accélérer le phénomène de démagnétisation en ouvrant l'interrupteur 622 (Hi = 0), pour que le courant de démagnétisation traverse l'impédance de forte valeur 621. Il apparaît alors aux bornes de l'enroulement secondaire, Ws une tension plus importante, de courte durée, dont l'aire D est égale à

$$D = B - (A + C)$$

Dans un système comme le convertisseur décrit en relation avec les figures 8 à 12, il est aisé d'élaborer un signal de commande Hi de l'interrupteur 622, puisqu'il y a une relation entre la commande des interrupteurs Tp et Ts et le passage du courant Ip. Un exemple est donné sur la figure 10. Le circuit 82 déjà décrit comporte en outre une bascule D 826 dont l'entrée D est à 1. L'entrée de remise à zéro CL de cette bascule D reçoit la sortie /Q de la bascule 825, l'entrée d'horloge CK reçoit la sortie d'un comparateur 827. Le comparateur 827 reçoit sur son entrée positive la rampe de tension Vb délivrée par le circuit 823, et sur son entrée négative une fraction de la tension Va délivrée par le circuit 821, appliquée par l'intermédiaire d'un pont diviseur de tension 828. La sortie /Q de la bascule 826 délivre le signal de commande Hi du capteur de courant 62. La figure 11 représente la forme des signaux Hp et Hs destinés aux interrupteurs Tp et Ts du convertisseur, ainsi que le signal Hi de commande du capteur 62. On voit que Hi est à 0 pendant une partie de la période T3. Si l'on se réfère à nouveau à la figure 10, il apparaît que le signal Hi passe à 0 à l'instant où la rampe de tension Vb devient égale à la fraction de Va appliquée au comparateur 827, et revient à 1 lorsque le signal S(T3) est émis (ouverture de Tp). Ainsi, lorsque Hi est à 0 et que l'interrupteur 622 est ouvert, le courant Ip est toujours nul et le capteur peut se démagnétiser. La durée de la phase de démagnétisation peut être réglée au moyen du diviseur de tension 828.

La figure 15 représente un mode de réalisation particulier du capteur 62. L'interrupteur 622 est un transistor MOS de type 2N7002, dont la grille G est attaquée par le signal Hi, le drain D connecté à Ws, et la source S connectée à la résistance de mesure r. L'impédance 621 est une résistance d'une dizaine de kΩ, et la résistance de mesure r est de l'ordre de la dizaine d'ohms. L'enroulement primaire Wp ne comporte qu'une spire et l'enroulement secondaire Ws présente 200 spires. L'impédance 621 est connectée en parallèle aux bornes de l'interrupteur 622, la référence de potentiel 623 du capteur étant prise entre la résistance r et la source S du transistor MOS 622.

L'homme du métier notera que le capteur de courant selon l'invention est susceptible de nombreuses applications autres que celle qui vient d'être décrite. D'une façon générale, un tel capteur est utilisable pour mesurer ponctuellement un courant dans tout circuit commandé dans lequel il y a un lien entre le passage du courant et l'état des commandes du circuit, à partir desquelles il sera possible d'élaborer un signal de fermeture et d'ouverture de l'interrupteur du capteur.

**Revendications**

1. Capteur de courant (62), fournissant la valeur signée d'un courant à mesurer et comprenant:

   un transformateur (620) comportant un enroulement primaire (Wp) et un enroulement secondaire (Ws), l'enroulement primaire (Wp) étant connecté pour être traversé par le courant à mesurer,
   une impédance (621) de démagnétisation du transformateur, connectée pour agir quelle que soit la polarité du courant fourni par l'enroulement secondaire,
   une résistance de mesure (r) dont une borne est directement connectée à une borne de l'enroulement secondaire (Ws),
   un interrupteur bidirectionnel (622) dont une borne est directement connectée à la seconde borne de l'enroulement secondaire, et dont la seconde borne est directement connectée à la seconde borne de la résistance de mesure,

des moyens de commande dudit interrupteur (622) pour fermer l'interrupteur quand un courant (Ip) est susceptible de traverser l'enroulement primaire (Wp), et ouvrir l'interrupteur pendant un laps de temps suffisant pour assurer la démagnétisation du transformateur (620), quand aucun courant (Ip) n'est susceptible de traverser l'enroulement primaire (Wp).

2. Utilisation du capteur de courant (62) selon la revendication 1, dans un convertisseur bidirectionnel à stockage inductif pour mesurer le courant dans un élément de stockage inductif (1).

3. Capteur de courant selon l'une des revendications 1 et 2, caractérisé en ce que ladite impédance de démagnétisation (621) est connectée en parallèle aux bornes de l'enroulement secondaire (Ws).

4. Capteur de courant selon l'une des revendications 1 et 2, caractérisé en ce que ladite impédance de démagnétisation (621) est connectée en parallèle aux bornes de l'interrupteur (622).

5. Capteur de courant selon la revendication 1, caractérisé en ce que ledit laps de temps commence un intervalle de temps prédéterminé après la fin d'une période où le courant est susceptible de circuler dans l'enroulement primaire, et se termine un intervalle de temps avant le début de la prochaine période où le courant est susceptible de circuler dans l'enroulement primaire.

**Patentansprüche**

1. Strom-Meßfühler bzw. -Meßwandler (20), welcher den mit Vorzeichen versehenen Betrag eines zu messenden Stroms liefert und umfaßt:

   einen Transformator (620) mit einer Primärwicklung (Wp) und einer Sekundärwicklung (Ws), wobei die Primärwicklung so angeschlossen ist, daß sie von dem zu messenden Strom durchflossen wird,

   eine Impedanz (621) zur Entmagnetisierung des Transformators, in solcher Anschlußverbindung, daß sie unabhängig von der Polarität bzw. Richtung des von der Sekundärwicklung gelieferten Stroms wirksam ist,

   einen Meßwiderstand (r), dessen einer Anschluß direkt mit dem einen Anschluß der Sekundärwicklung (Ws) verbunden ist,

   einen bidirektionalen Unterbrecherschalter (622), dessen einer Anschluß direkt mit dem zweiten Anschluß der Sekundärwicklung und dessen zweiter Anschluß direkt mit mit dem zweiten Anschluß des Meßwiderstands (r) verbunden ist,

   Schaltmittel zur Steuerung des genannten Unterbrecherschalters (622) derart, daß der Schalter geschlossen wird, wenn ein Stromfluß (Ip) durch die Primärwicklung zu erwarten ist, und daß der Schalter während einer ausreichenden Zeitdauer, um die Entmagnetisierung des Transformators (620) zu gewährleisten, geöffnet wird, wenn kein Stromfluß durch die Primärwicklung (Wp) zu erwarten ist.

2. Verwendung des Strom-Meßfühlers bzw. -Meßwandlers (62) nach Anspruch 1 in einem bidirektionalen Umformer mit induktiver Speicherung, zur Messung des Stroms in einem induktiven Speicherelement (1).

3. Strom-Meßfühler bzw. -Meßwandler nach einem der Ansprüche 1 und 2, dadurch gekennzeichnet, daß die genannte Entmagnetisierungsimpedanz (621) in Parallelschaltung an den Anschlüssen der Sekundärwicklung (Ws) angeschlossen ist.

4. Strom-Meßfühler bzw. -Meßwandler nach einem der Ansprüche 1 und 2, dadurch gekennzeichnet, daß die genannte Entmagnetisierungsimpedanz (621) in Parallelschaltung an den Anschlüssen des Unterbrecherschalters (622) angeschlossen ist.

5. Strom-Meßfühler bzw. -Meßwandler nach Anspruch 1, dadurch gekennzeichnet, daß die genannte Zeitdauer in einem vorgegebenen Zeitintervall nach dem Ende einer Periode, in welcher ein Stromfluß in der Primärwicklung zu erwarten ist, beginnt und in einem Zeitintervall vor Beginn der nächsten Periode, in welcher der Stromfluß in der Primärwicklung zu erwarten ist, endet.

**Claims**

1. A current sensor providing the signed value of a current to be measured and including:

   a transformer (620) having a primary winding and a secondary winding, the primary winding being connected to be run through by the current to be measured,
   a demagnetization impedance (621) for demagnetizing the transformer, connected to act whatever the polarity of the current provided by the secondary winding,
   a measuring resistor (r), having a first terminal directly connected to a first terminal of the secondary winding,
   a bidirectional switch (622) having a first terminal directly connected to the second terminal of the secondary winding, and a second terminal directly connected to the second terminal of the measuring resistor,
   means for controlling said switch for closing the switch when said current is likely to run through the primary winding, and opening the switch for a time interval sufficient to ensure the demagnetization of said transformer, when no current is likely to run through the primary winding.

2. Use of a current sensor (62) according to claim 1 in a bidirectional flyback converter for measuring the current in an inductive storage element (1).

3. A current sensor according to claim 1, wherein said demagnetization impedance is connected in parallel across said secondary winding.

4. A current sensor according to claim 1, wherein said demagnetization impedance is connected in parallel across said switch.

5. A current sensor according to claim 1, wherein said time interval starts a predetermined delay after the end of a period where the current is likely to flow in the primary winding, and ends a time interval before the beginning of the next period where the current is likely to flow in the primary winding.

Fig 1a

Fig 1b

Fig 1c

Fig 1d

Fig 1e

Fig 2

Fig 3

Fig 4a

Fig 4b

Fig 4c

Fig 4d

Fig 4e

Fig 4f

Fig 4g

Fig 4h

Fig 4i

Fig 4j

Fig 5

Fig 6

Fig 7

Fig 9

Fig 8a

Fig 8b

Fig 8c

Fig 8d

Fig 8e

Fig 10

Fig 11

Fig 11bis

Fig 12

Fig 13

Fig 14

Fig 15